# EUROPEAN PATENT SPECIFICATION

(11) **EP 1 655 844 B1**
(45) Date of publication and mention of the grant of the patent: **12.08.2009**
(21) Application number: 05108120.6
(22) Date of filing: 05.09.2005
(51) Int. Cl.: H03M 13/17, H04L 1/00

(54) **Method of transmitting digital data packets and apparatus implementing the method**
Verfahren zur Übertragung von digitalen Datenpaketen und Vorrichtung zur Durchführung des Verfahrens.
Procédé pour la transmission de paquets de données numériques et appareil pour sa mise en ouvre.

(30) Priority: 09.09.2004 FR 0452010
(43) Date of publication of application: 10.05.2006
(73) Proprietor: Thomson Licensing, 92100 Boulogne-Billancourt (FR)
(72) Inventor: Champel, Mary-Luc, 92648 Boulogne Cedex (FR); Maillet, Arnaud, 92648 Boulogne Cedex (FR); Gandia, Sebastien, 92648 Boulogne Cedex (FR)
(74) Representative: Le Dantec, Claude

(56) References cited:
- US-A- 6 079 042
- SHACHAM N: "Packet recovery and error correction in high-speed wide-area networks" MILCOM 89, 15 October 1989 (1989-10-15), pages 551-557, XP010083508
- KALATHUR R ET AL: "Forward error correction with buffer management in multimedia ATM networks" SOUTHCON /94. CONFERENCE RECORD. ORLANDO, MAR. 29 - 31, 1994, NEW YORK, IEEE, US, 29 March 1994 (1994-03-29), pages 437-444, XP010157996 ISBN: 0-7803-9989-7
- "Pro-MPEG Code of Practice #3" PRO-MPEG FORUM, 26 July 2004 (2004-07-26), XP002308517

## Description

The present invention relates to error correction within the framework of the despatching of digital data in packet form and more precisely the manner of customizing an orthogonal FEC scheme with regard to nonrectangular matrices as a function of the size of the buffer of the receiver apparatus.

When despatching digital data over a network in the form of data packets, it may happen that transmission errors affect the packets. The networks allowing the transfer of digital data in the form of packets have their own characteristics, such as bandwidth, latency or reliability, which vary from one type of network to another. Depending on the type of network, it is possible to note a different sensitivity to various types of errors apt to occur during packet data transmission over this network. Among the types of errors apt to occur are the transmission of a packet with an erroneous bit, the loss of a packet randomly, the loss of a string of adjacent packets, the duplication of a packet or a string of packets.

To cope with these errors, two types of methods traditionally exist. On the one hand the error detection methods, which make it possible to detect that a packet transmitted is erroneous and to ignore it. Generally these methods are used when the transmission protocol makes it possible to ask for a new despatch of the lost packet. Mention may be made here of the CRC method (Cyclic Redundancy Checking) and the TCP protocol (Transfer Control Protocol) on IP type networks. On the other hand, methods exist which allow, not only the detection of an erroneous packet, but also its reconstruction. These methods are known by the acronym FEC (Forward Error Correction) and are well suited to protocols where the request to resend an erroneous data packet is not possible. Mention may be made here of the case of protocols for transmitting multimedia content in real time where compliance with real time is incompatible with the resending of erroneous packets. The RTP protocol (Real Time Protocol) corresponds to this latter case.

Document entitled "Packet recovery and error correction in high-speed wide-area networks" from Nachum Shacham published in MILCOLM 89 on October 15, 1989 (pages 552-557) discloses a technique for recovering lost packets by means of forward error correction.

The document "Transmission of professional MPEG-2 transpont streams over JP networks" (Pzo-MPEG- Code of Practice #3, Release 2, July 2004) XP -002308517, discloses a Non-Block- Aligned FEC arrangement with non- retangular matrixes.

The general principle of operation of FEC methods is the application of a function, for example an XOR, to a set of data packets. The result of this function gives a packet, called a corrector packet, which is transmitted over and above the data packets that served to generate it. When a packet is detected as being erroneous, the corrector packet, associated with the correctly transmitted packets, makes it possible to reconstruct the erroneous packet. However, this method has limits in the sense that errors exist which are not correctable. Specifically, if two packets are erroneous in the set of packets that served to generate a corrector packet through the XOR function, then the corrector packet will not suffice to reconstruct the two erroneous packets. The strategy used in choosing the packets serving to generate the corrector packet is therefore crucial to the effectiveness of the correction method. In particular, this strategy will depend on the type of errors arising most often on the type of network used. For example the calculation of the correction function on N contiguous packets will make it possible to correct random errors that are not too numerous but will be powerless against a series of lost packets. To cope with series of lost packets, it is known, for example in the document "Code of Practice" of the Pro-MPEG forum, to calculate the correction function on a set of D packets taken periodically every L packets. The function is applied, to the packets i,i+L,i+2L,...,i+(D-1)L. In this way a series of erroneous packets of at most L contiguous packets will be correctable by the method.

In a known manner, the error corrector packets are calculated by accumulation in a register of the contribution of each packet contributing to its calculation. The despatching in the stream of the error packet is then performed just after the despatching of the last packet that served to calculate it.

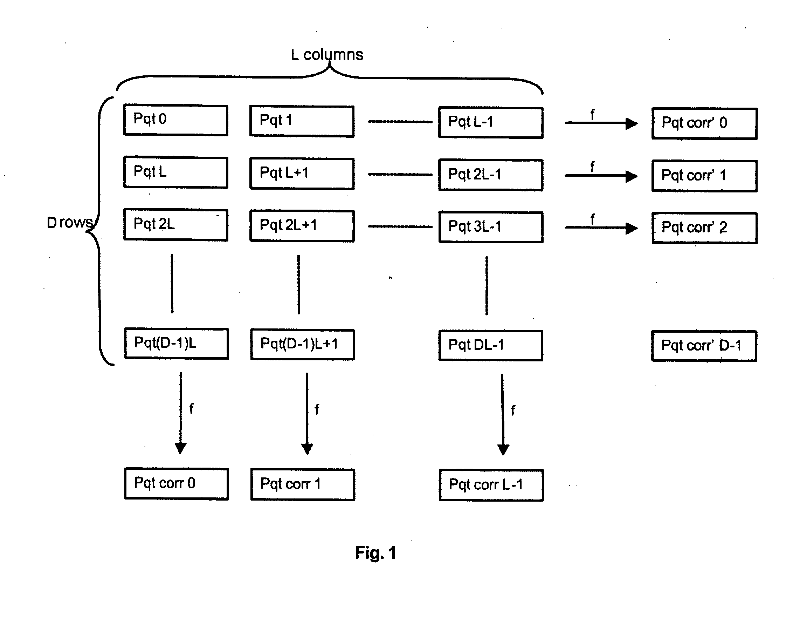

An improvement to this method consists, if the data packets are considered to be arranged in a matrix of D rows and L columns, in applying the function to the rows and to the columns of this matrix. A diagram of the scheme of this known method is given in Figure 1. In this case the function is applied not only to the packets, i,i+L,i+2L,...,i+(D-1)L but also to the packets i,i+1,i+2,...,i+L-1. In this way, each data packet serves in the calculation of two corrector packets, and the correction rate in the presence of random errors increases significantly while retaining good correction of series of erroneous packets.

An extension of this method consists in authorizing the definition of a second length of row L', L' being a divider of L*D or 0, and of applying the correction function to rows of length L' instead of L to obtain the row corrector packets. A length L' equal to 0 signifying that no row correction is made but only a column correction. In this way a number D'=L*D/L' of row corrector packets is generated for L*D data packets.

When no scheme for sequencing the FEC corrector packets is specified, the latter are naturally inserted into the stream of data packets as soon as they are calculated. Each row corrector packet is despatched after the last data packet of the row that it protects. Each column corrector packet is despatched after the last data packet of the column that it protects. Such a sequencing has the advantage of not requiring the storage of the corrector packets during despatch and that the row corrector packets are regularly inserted into the stream.

On the other hand between the despatching of each matrix of data packets, it involves the despatching of a set of column corrector packets that is associated with the matrix which has just been despatched. Under certain conditions this may be unacceptable because it introduces too large an irregularity into the stream of data packets for the receiver to be able to ensure fine synchronization of the data on account of the overly long time span during which it does not receive any more data packets.

Moreover each column corrector packet being despatched subsequent to a data packet that it protects, the occurrence of a series packet loss will cause the concomitant loss of data packets and of the associated corrector packet making it impossible to reconstruct the lost data.

To solve these problems, it is possible to use matrices called nonrectangular matrices. These matrices are defined by an FEC scheme where the base packets of the columns of the matrix are no longer contiguous packets. The rows, for their part, remain based on sets of contiguous packets. Such a scheme makes it possible, while preserving a despatch of corrector packets as soon as they are available, to distribute the corrector packets naturally in the stream although requiring the use of a slightly larger reception buffer.

Concerning the columns, the corrector function is still calculated over the same number of packets D, but the index of the first few packets of each column now alters by an increment of L-1 instead of 1 in the case of conventional rectangular matrices. As far as the insertion of the column corrector packets is concerned, they are still inserted at a distance of at least L+1 packets from the last data packet of the column that they protect. This is important for guaranteeing that the method is still capable of correcting series of consecutive losses of packet whose length is at most L packets. The advantage of this solution compared with the rectangular matrix based approach is the natural and regular sequencing of the corrector packets but it has the drawback of involving the use of larger reception buffers introducing greater latency.

The invention relates to a mechanism for choosing the parameters of the FEC scheme (L and D) for a nonrectangular matrix which simultaneously offers a better error correction rate, a lesser latency and a lesser overhead in terms of corrector packets. It consists in the observation that by choosing a reception buffer size altering between a minimum size and the maximum size making it possible to store the entire nonrectangular matrix one obtains a much better compromise between the correction rate and the latency induced than by limiting oneself to buffer sizes making it possible to store the totality of the matrix although this involves renouncing the correction of all the theoretically correctable errors.

The invention relates to a method of transmitting a stream of digital data packets comprising:
- at the level of the sender a step of safeguarding said data packets with error corrector packets calculated by applying a corrector function to rows and columns of these data packets arranged within matrices, the rows and the columns of the matrix being defined by the index of the first packet, an increment step size and the total number of packets of which they are composed;
- at the level of the receiver a step of storing the data packets and the corrector packets received;
- at the level of the receiver a step of reconstructing the lost packets consisting of the application of the corrector function to the set of packets stored;
characterized in that the reconstruction function is applied to a restricted set of packets not containing all the data packets and the corrector packets involved in the protection of a matrix of data packets.

The invention will be better understood and other features and advantages will become apparent on reading the description which follows, the description making reference to the appended drawings among which:
Figure 1 represents a diagram of the calculation of the row and column corrector packets in an exemplary embodiment of the invention.
Figure 2 represents an exemplary sequencing according to the first method of sequencing.
Figure 3 represents an exemplary sequencing according to the second method of sequencing.
Figure 4 represents an exemplary sequencing according to the third method of sequencing.
Figure 5 represents the structure of a corrector packet placed in a packet according to the RTP protocol.
Figure 6 represents the header of a corrector packet according to RFC 2733.
Figure 7 represents the header of a corrector packet according to the described exemplary embodiment of the invention.
Figure 8 represents an exemplary sequencing according to the fourth method of sequencing.
Figure 9 represents an exemplary sequencing according to the fifth method of sequencing.
Figure 10 represents the hardware architecture of a sender or receiver apparatus according to the exemplary embodiment of the invention.
Figure 11 represents an exemplary minimum partial buffer.
Figure 12 represents results of simulating use of a partial buffer.
Figure 13 represents a comparison of simulation results for a scheme with complete buffer versus a partial buffer.
Figure 14 represents another comparison of simulation results for a set of FEC schemes.
Figure 15 represents an exemplary error configuration that is noncorrectable with the partial buffer.
Figure 16 represents an exemplary error configuration that is correctable with the partial buffer.

The exemplary embodiment of the invention sits within the framework of the transfer of digital data in real time over an IP type network. The data are transmitted, in this exemplary embodiment, in the form of a stream via the RTP protocol (Real Time Protocol). RFC 2733 describes a standard way of correcting the data packets transmitted by the RTP protocol. This method has formed the subject of an extension described in the document "Code of Practice" of the Pro-MPEG forum.

In this exemplary embodiment, the data packets are arranged as rows of L packets. Consideration will be given hereinbelow to matrices of D rows of L packets as may be seen in Figure 1. L and D are chosen as a function of the effectiveness that one wishes to obtain. The way in which these parameters influence the effectiveness of the correction method will be described later. A corrector function is then applied to each column of the matrix. Then a second row length, L', is defined, which is potentially different from the length of the row of the matrix L. The only constraint on L' is that it be a divider of L*D or 0. The same corrector function is also applied to each string of L' consecutive packets of the matrix.

It is also useful to generalize the concept of matrix, initially viewed as a rectangular array of D rows and L columns containing the data packets arranged consecutively from left to right and from top to bottom. To this end we shall define a concept of matrix, termed nonrectangular, where the rows and the columns are defined by a base index, a number of packets and an increment step size. Hence a row or a column of such a nonrectangular matrix will be defined as composed of the data packets of index i,i+p,i+2p,i+(n-1)p where i is the base index, p the increment step size and n the number of packets. This number of packets therefore corresponding to the size of the correction rows L', potentially different from the size of the rows of the matrix, or to the size of the columns D of the nonrectangular matrix generalizing the concept of rectangular matrix.

This corrector function may be an XOR, this being the simplest to implement, but other functions are possible such as the Reed-Solomon or a Hamming code. These functions are more competitive but more expensive calculationally. Regardless of the correction function chosen, the result of the application of this function to a set of packets, a row or a column of the matrix in this instance, results in a packet that may be referred to as a corrector packet. The method therefore results in L column corrector packets corresponding to the application of the function to each column and D' row corrector packets corresponding to the application of the function to each row. It is also possible to add a corrector packet calculated by applying the corrector function to the corrector packets themselves, thereby adding a second level of protection making it possible to correct a loss of a corrector packet.

These packets must be transmitted to the destination of the data stream. This transmission may be done in several ways. It is possible to transmit these corrector packets in the same stream as the data packets, but they are then subject to the same vagaries of transmission as the stream that they protect. They may also be transmitted in a separate stream, thereby increasing the resistance to errors.

The method described by the Pro-MPEG forum consists in calculating and in despatching the corrector packets calculated on the basis of the columns of the matrix. The method described here, in so far as it despatches these same packets, remains compatible with that of Pro-MPEG. Specifically, receiver apparatuses according to this standard will ignore the corrector packets calculated on the rows of the matrix and will therefore be able to operate in the same way with a sender according to the invention and with a sender according to the Pro-MPEG method.

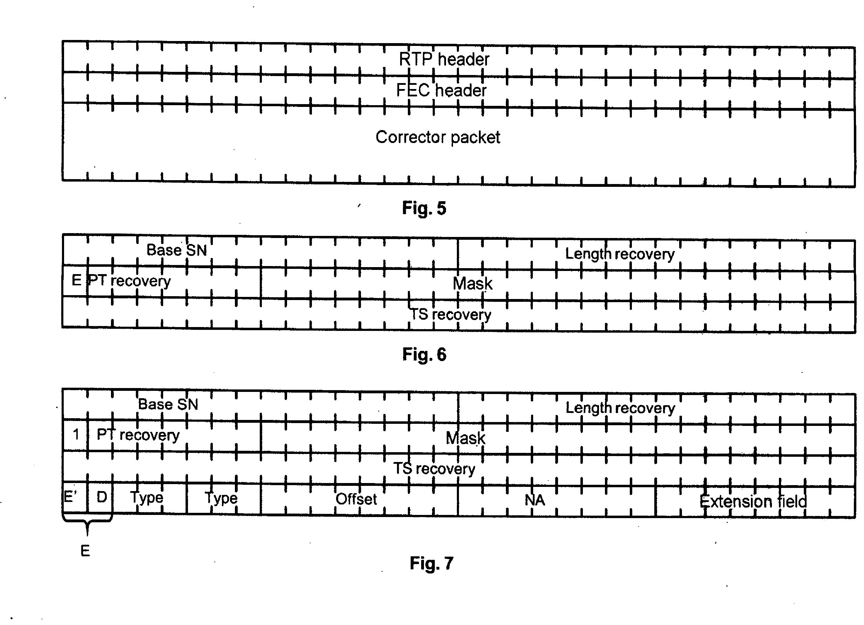

The structure of a packet, as described in RFC 2733 is represented in Figure 5. It consists of an RTP packet header whose description may be found in RFC 1889. This header is followed by an FEC header then by the corrector packet proper. The structure of an FEC header according to RFC 2733 is represented in Figure 6. This header contains a field "base SN" which contains the lowest sequence number of the set of data packets that served in the construction of the corrector packet. The "length recovery" field is used to determine the length of any data packet. It is constructed by applying the corrector function to the set formed of the lengths of each data packet. The "E" field serves to indicate an extension of the header. The "PT recovery" field is obtained by applying the corrector function to the "type" field of the data packet. The "mask" field is a field of 24 bits which serves to determine which data packets are the ones serving in the construction of the corrector packet. If bit i is at one, this signifies that it is the packets N + i which served for the construction of the corrector packet. N is the base stored in the "base SN" field. The "TS recovery" field is calculated by applying the corrector function to the time stamps of the data packet. It allows the reconstruction of these stamps.

It may be seen that through this mechanism it is possible only to calculate corrector packets on sets of a maximum of 24 data packets. To overcome this constraint, an extension of this header is defined in the document "Code Of Practice" of the Pro-MPEG forum. This extension is represented in Figure 7. Found therein is the same header as previously where the extension field is stamped at 1. A new extension field "E" on 2 bits is added which determines the use of the "extension field" field. The "type" field indicates which corrector function is used, 0 for the XOR, 1 for a hamming code, 2 for a Reed/Solomon. The "index" field is used to order the FEC packets in the case where the result of the corrector function would exceed the maximum size of a packet. This may be the case for complex corrector functions. The "offset" field determines the period chosen to select the data packets, it corresponds to the parameter L of the matrix. The "NA" field (Number of Associated) determines the number of associated data packets for the generation of the corrector packet, this number corresponds to the parameter D of the matrix. The "extension field" field is reserved for future use. The "mask" field has become unnecessary and is initialized with padding bytes to 0.

The modification as compared with RFC 2733 consists in separating the "E" field of two bits, into a new "E"' field on one bit and a "D" field on one bit likewise which determines whether the corrector packet in question is calculated on the columns, in which case this "D" field is set to 0. In the case where the corrector packet is calculated on a row, this field D is set to 1. It may be seen that through this mechanism, a corrector packet calculated on a column remains perfectly identical to the same packet calculated according to the method of the Pro-MPEG forum, while the additional packets calculated on the rows are identifiable through the presence of the field D at 1, this amounting to setting the two-bit extension field "E" to one if the packet is interpreted according to the Pro-MPEG method signalling that this packet uses an extension of the format defined by the forum.

On receipt of the packets, the receiver will store in a buffer the packets received. The size of this buffer must make it possible to store at least L times D data packets plus the L plus D' corresponding corrector packets. The distinction between the data packets and the corrector packets is made by the "type" field of the RTP header as described in RFC 1889 describing this protocol. It will be possible to identify the data packets among one another by virtue of their sequence number and the corrector packets among one another by virtue of the "base SN" field of their header. Knowledge of the missing packets will then make it possible to attempt their reconstruction by using the corrector function and the corrector packets. For example, if the corrector function used is the XOR, it is possible to correct the loss of a data packet in a set of data packets that served to generate a corrector packet, with the aid of this corrector packet. Hence, in the matrix of packets received, we will tag the rows and the columns containing only a lost packet so as to reconstruct them with the corresponding corrector packet. The correction may, for example, be made by the following method:
- Calculation of a vector NLi of the number of missing data packets in row i.
- Calculation of a vector NCi of the number of missing data packets in column i.
- While there remains a missing packet in the matrix do:
   o Find the minimum index p such that NLp = 1;
      ■ If such a p exists:
         - Find the column index q corresponding to the missing packet
         - reconstruct the packet of index p and q which is missing by applying the XOR function to the other packets of the row and to the corrector packet corresponding to this row
         - NLp = 0; NCq = NCq-1;
      • In the absence of such an index p find a minimum index q such that NCq = 1
         - If such a q exists:
            o Find the column index p corresponding to the missing packet
            o Reconstruct the packet of index p and q which is missing by applying the XOR function to the other packets of the row and to the corrector packet corresponding to this column
            o NLp = NLp-1; NCq = 0;
         - Otherwise the reconstruction method has failed.

In the event of success, all the lost packets are reconstructed.

The parameters L, L' and D of the method will have to be chosen by taking account of the following information. Firstly, the surplus generated by the corrector packets which have to be despatched in addition to the data packets is 1/L'+1/D, it may therefore be seen that choosing L' and D large will minimize the occupancy of the bandwidth required for the use of the method. Moreover the method makes it possible to correct series of lost packets of at most L+1 contiguous packets, hence the larger is L the more effective the method will be in the correction of errors of this type. The method is capable of correcting all the random losses of packets up to a number of three lost packets and certain random losses of packets up to a number of D+L-1 lost packets. The symmetry of the problem induces a maximum effectiveness on random losses of packets when L and D have the same value. Now, the method requires buffers in the sending apparatuses and in the receiving apparatuses, of a minimum size of L*D packets. It may therefore be seen that it is beneficial to choose values of L' and D that are large so as to maximize the effectiveness of the method but that one is limited by the size of the send and receive buffers of the apparatuses. Another limitation may arise from the calculation time of the corrector function which may become significant for a large number of packets and a complex function choice.

Statistical calculations make it possible to compare the effectiveness of this method with that described by the Pro-MPEG forum. It is noted that, as expected, its effectiveness is much greater. For example, by using the XOR corrector function and a matrix where L, L' and D have a value of 6, the method corrects 94.1 per cent of random losses of 6 data packets whereas the RFC method corrects only 2.4 per cent. The method therefore turns out to be much more effective for the correction of random losses of data packets in the stream. Whereas the method is capable of correcting all the losses of adjacent packets up to a number of D+1 successive packets, precisely where the Pro-MPEG method corrects only up to a number of D. It may therefore be seen that the performance with regard to the loss of adjacent data packets is slightly improved whereas the performance with regard to random errors is very greatly increased.

Several choices of sequencing of the error corrector packets within the stream of data packets will now be described together with the impact of these choices on the error correction method.

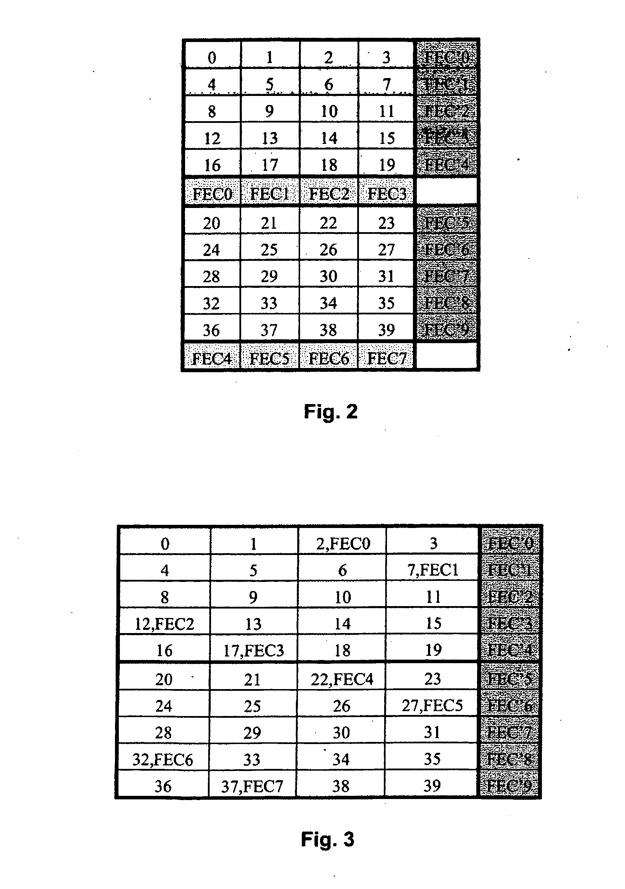

We shall take as reference the arrangement of the data packets in a rectangular matrix of D=5 rows and L'=L=4 columns, as illustrated in Figure 2. On the one hand, with the aim of simplification, we shall choose the length of correction row L' equal to the length of the row of the matrix L, but the invention extends to any value of L' dividing L*D or 0. The packets FEC'i are calculated on the basis of the data packets of row i whereas the packets FECi are calculated on the basis of the packets of the corresponding column, for example the packet FEC2 is calculated on the basis of packets 2, 6, 10, 14 and 18. A conventional sequencing method consists in inserting the corrector packets immediately following the last data packet that served to calculate them. In the example, this conventional sequencing leads to despatching the packets in the following order:0,1,2,3,FEC'0,4,5,6,7,FEC'1,...,FEC'3,16,FEC0,17, FEC1,18,FEC2,19,FEC3,FEC'4.

The correction of the loss of a series of consecutive packets, this series possibly containing data packets and corrector packets, is correctable on condition that for each lost data packet, the column corrector packet protecting it is available. One is therefore certain of being able to correct any series of lost consecutive packets containing at most L data packets or column corrector packets protecting one of the data packets of the series. It will therefore be possible to guarantee the correction of any series of packets containing at most L data packets on condition that all the column corrector packets are inserted into the stream at a distance such that there are at least L-1 packets between the last data packet that it corrects and the point of insertion. It should be noted that it is sometimes possible to correct the loss of a series of consecutive packets containing up to 2L packets, but this is not guaranteed.

This sequencing poses the problem of the correction of the losses of series of consecutive packets. Specifically, while the loss in series of L consecutive packets is correctable in general by virtue of the column FEC packets, if it occurs for the last row where the data packets and the column FEC packets are interleaved, this same error will not be correctable.

A first method making it possible to remedy this problem consists in despatching all the column FEC packets in series after despatching the last row corrector packet, FEC'4 in the example. The despatch sequence therefore becomes in the example: 0,1,2,3,FEC'0,4,5,6,7,FEC'1,...,FEC'3,16,17, 18,19,FEC'4,FEC0,FEC1,FEC2,FEC3.

It may therefore be seen that in this case it is still possible to correct the loss of a series of packets, data plus FEC, of at most L+1 packets, L data packets and a row corrector packet.

On the other hand this way of doing things poses the problem that one despatches a consecutive series of at least D error corrector packets, the last row packet, if it exists, followed by the D column packets. As a function of the size of the matrix this causes a longer or shorter time where no data packet is despatched, and the regularity in the despatching of the data is lost.

To cope with this problem, a second method consists in storing in a buffer all the packets of the matrix and in calculating all the corrector packets, rows and also columns. Then the despatching of the column corrector packets can be distributed within the despatching of the data packets in a regular manner, for example every N packets. The row corrector packets remaining despatched consecutively with the despatching of the data packets constituting the row that served to calculate them. This sequencing is illustrated by Figure 3 where the order of despatch of the packets is read from left to right and from top to bottom. When several packets are indicated in one and the same box, they are despatched in the order in which they appear. A judicious way of choosing the increment N is to choose N = L/2 if the number of rows D is greater than or equal to the number of columns L and N = D otherwise, but it will be apparent to the person skilled in the art that any other regular distribution of the column corrector packets in the matrix possesses the same properties.

In this way the stream of data packets is regular, whereas the need to store the packets introduces a latency into the transmission of the packets. On the other hand, the column corrector packets are still despatched at a distance of less than L-1 packets from one of the packets that served to calculate them, hence no benefit is derived from the resistance to the loss of a consecutive series of L packets that we had in the first method.

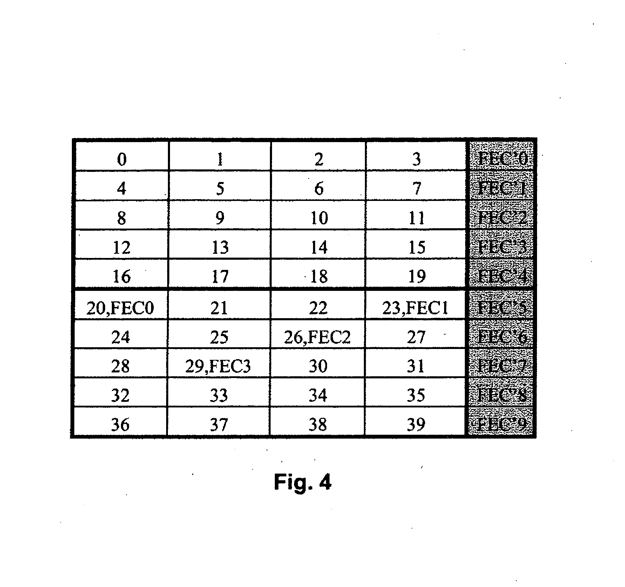

A third method consists in distributing the column corrector packets in the following matrix of data packets, as illustrated by Figure 4. One way of doing this consists in inserting the first column corrector packet after the first data packet of the following matrix. This ensures that it will be at a distance greater than L-1 from the previous one. In this way we recover the resistance to the loss of series of consecutive packets of L packets. The distribution of the corrector packets is regular in the stream of data packets. Moreover, it is no longer necessary to delay the despatching of the data packets at the source level. On the other hand, the data packets of the matrix must be stored at the destination level until the receipt of the last column corrector packet for the reconstruction of the lost packets. The method therefore involves a latency at the destination level. Here again it will be apparent to the person skilled in the art that any other regular distribution of the column corrector packets in the following matrix possesses the same properties.

A fourth method explores the possibility of using nonrectangular matrices. Specifically, the definition of the error correction scheme is based on the calculation of error packets defined by three parameters included in the header of these packets. This header is illustrated in Figure 7. A corrector packet is therefore defined by a field SN corresponding to the index of the first data packet that served to calculate it, an "offset" field determines the period chosen for selecting the data packets, it corresponds to the parameter L of the matrix. The "NA" field (Number of Associated) determines the number of associated data packets for the generation of the corrector packet, this number corresponds to the parameter D of the matrix.

The obtaining of the rectangular matrix generally used corresponds therefore, for the row corrector packets, to using a step size (offset) of 1, a number of L' and in incrementing the base index by L' commencing with the index of the first data packet of the matrix. The column corrector packets being obtained by a step size of L, a number of D, and by incrementing the base index by 1 starting from the index of the first data packet of the matrix.

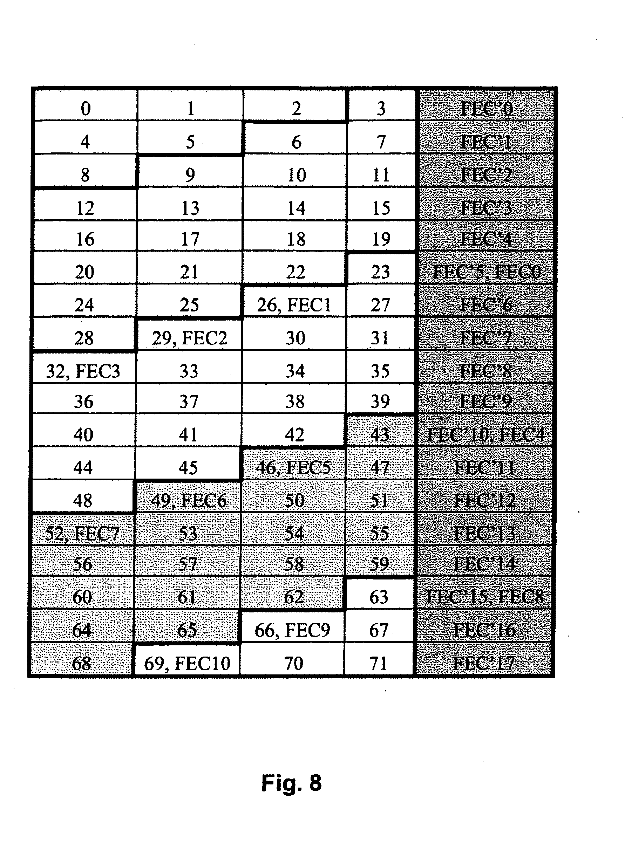

The way in which the base index of the column corrector packets is altered makes it possible to define a matrix, termed nonrectangular, by changing the increment of 1 of the base index. For example, such a matrix is illustrated in Figure 8. It may be seen that the row corrector packets are still calculated in the same way on a row consisting of L' data packets of consecutive indices. Certain rows therefore contain packets belonging to two consecutive nonrectangular matrices. On the other hand the column corrector packets are calculated on a column of D packets but the base indices of two consecutive columns are no longer sequential and the base index of column i+1 minus that of column i is different from L. In the example given, packet FEC0 is calculated on the data packets 3, 7, 11, 15 and 19, packet FEC1 is calculated on data packets 6, 10, 14, 18 and 22, packet FEC2 is calculated on data packets 9, 13, 17, 21 and 25 and packet FEC3 is calculated on data packets 12, 16, 20, 24 and 28.

A judicious, but not necessary, way of choosing these base indices of the columns consists in separating the base indices of two consecutive columns by a distance of D if L is greater than D and by L-1 otherwise.

The row corrector packets are still inserted in the same way at the end of the row of data packets that they protect. Whereas the column corrector packets are inserted at a distance at least equal to L-1 from the last data packet of the column that served to calculate it, an example is given in Figure 8.

The advantage of this method is of maintaining a regular stream where the corrector packets are distributed regularly in the stream of data packets. The effectiveness of the correction method is retained in the case of the loss of a series of consecutive packets since the column corrector packets are separated by at least L-1 packets from the packets that they protect. Neither is it necessary to store the data packets and to delay their despatch at source level. Hence no latency is generated at source level.

The drawback of this method is that, at the destination level, it is necessary to store all the rows containing at least one packet of the nonrectangular matrix so as to allow the reconstruction of the lost packets hence a little more than the nonrectangular matrix itself.

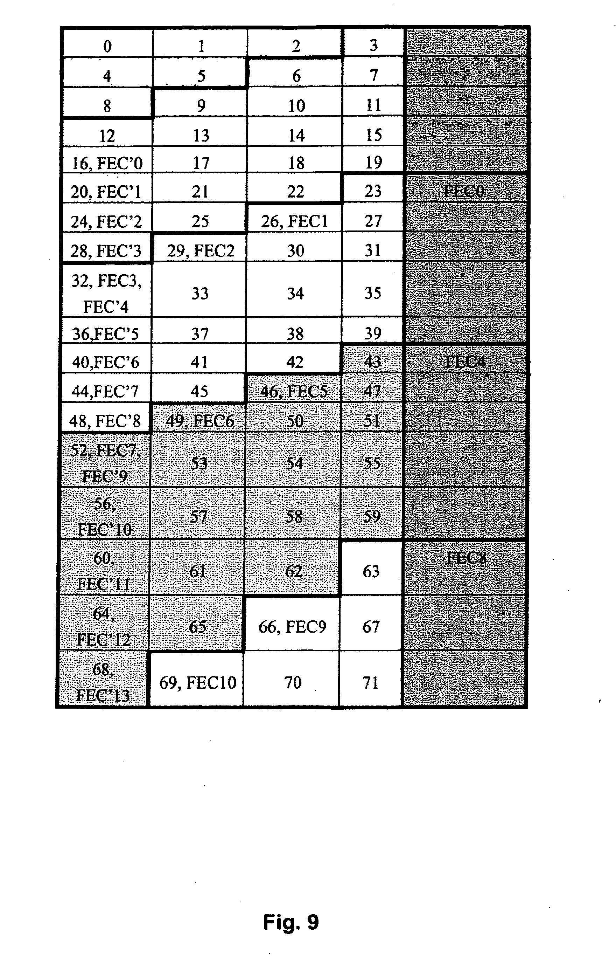

A fifth method consists in modifying the fourth by now changing the scheme of the rows. We define nonlinear rows of the matrix where the step size is no longer 1 but depends on the configuration chosen for the columns. If the distance between the base indices of the columns is L-1, we shall choose a step size of L-1. In the example illustrated in Figure 9, the method consists as rows serving to calculate the row corrector packets, no longer a row of consecutive index packets, but a diagonal. Hence the rows and the columns of the data packets of the nonrectangular matrix are used. In the example of Figure 9, packet FEC'0 is calculated using packets 3, 6, 9 and 12, packet FEC'1 is calculated using packets 7, 10, 13 and 16, packet FEC'2 is calculated using packets 11, 14, 17 and 20, packet FEC'3 is calculated using packets 15, 18, 21 and 24 and packet FEC'4 is calculated using packets 19, 22, 25 and 28. The column packets are still calculated according to the fourth method. An exemplary sequencing is indicated in Figure 9.

Concerning the sequencing, this time the row packets and also the column packets are inserted at a distance of at least L-1 packets from the last data packet that they protect. An example is given in Figure 9.

An advantage of this method is that it allows the reconstruction of the lost packets even in the case of the loss of two series of L consecutive packets and even, in certain cases, of the loss of a series of 2L consecutive packets. Another advantage of this method is of maintaining a regular stream when the corrector packets are distributed regularly in the stream of data packets. The effectiveness of the reconstruction method is retained, both in respect of the loss of series of consecutive packets and in respect of the loss of isolated packets. The corrector packets are calculated solely on the packets of the current matrix. At latency level, this method does not require the storage of the data packets at the source in buffers and therefore introduces no latency at source level.

When an FEC configuration is chosen for a nonrectangular matrix based approach, the parameters L and D are chosen in the following manner:
- L is related to the maximum size of a series of lost packets that the method will be capable of reconstructing, the method will still be capable of reconstructing series of L+1 consecutive lost packets.
- D is then chosen in such a way as to limit the relative quantity of corrector packets with respect to the data packets.

It will be noted that the overhead due to the corrector packets with respect to the data packets is still 1/D + 1/L as in the case of rectangular matrices.

Most of the time it is not necessary to choose a large value of L since the maximum size of the series of errors is generally fairly limited. Once L is fixed, then D will be chosen to be as large as possible so as to improve the correction rate while minimizing the surplus of packets generated.

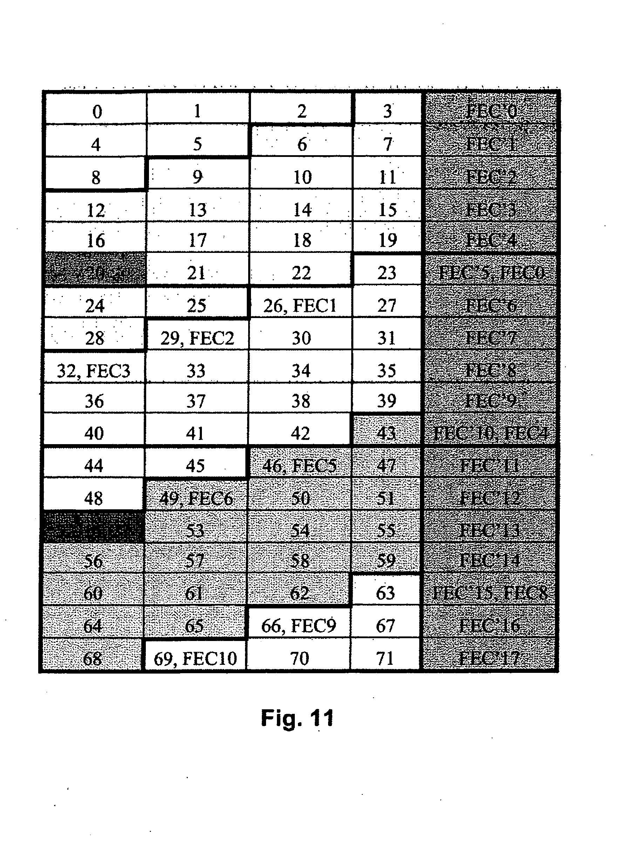

In this case, the factor limiting the choice of D will be the size of the reception buffer and hence the latency introduced at receiver level. Specifically, to ensure the correction of the lost packets, the receiver must be able to store all the data packets of a matrix as well as the corresponding corrector packets. In the case of nonrectangular matrices, a buffer of a minimum size of (L+1)*(D+2)+L²-2 packets is therefore necessary, see Figure 11 from packet 20 to packet FEC7. When the buffer actually available in the receiver is not very large, this size becomes limiting as regards the possible choices of L and D. Hence the idea of using choices of L and D with buffers in the receiver which are normally too small to store the whole of the matrix and its associated FEC corrector packets. Figure 11 also shows in bold line an exemplary partial buffer from packet 23 to packet FEC4.

The method relies on the possibility of considering smaller reception buffer sizes. This may seem surprising at first sight since a smaller buffer will obviously store fewer data packets and fewer corrector packets and will therefore not allow certain error corrections that a larger buffer would have allowed. On the other hand, this makes it possible to use a larger size of matrix and hence an FEC scheme having a better correction rate. A partial buffer will therefore be a buffer which will contain certain data packets in the matrix, namely those for which all the data packets and the corrector packets involved in their protection will not be present in the buffer. The consequence of this will therefore be that the function for reconstructing the lost packets will operate on a restricted set of packets and will therefore not be able to correct all the lost packets of the matrix that it would have been able to correct if it were applied to a nonrestricted set of packets.

The idea is therefore for a given size of buffer to use an FEC scheme having a better rate in a degraded manner (that is to say by using a partial buffer) rather than to limit oneself to the use of schemes with a poorer rate but used in an optimal manner (that is to say by using a complete buffer).

It is noted that the size calculated of (L+1)*(D+2)+L²-2 for the buffer is in fact the minimum size of the buffer allowing the optimal correction of the FEC scheme. If the size of the buffer is decreased, a moment occurs at which the buffer can no longer contain an entire column of data packets and the corrector packet corresponding to this column. If the buffer is reduced beyond this limit, the column correction becomes totally inoperative and the scheme is therefore busted. The minimum size of the buffer enabling the column scheme not to be busted is the following: (L+1)*(D+1)+2.

Stated otherwise, it is possible to vary the size of the buffer between the values of (L+1)*(D+1)+2 and (L+1)*(D+2)+L²-2 without busting the column correction. All these values will make it possible to vary a rate of degradation of the correcting effectiveness of the method.

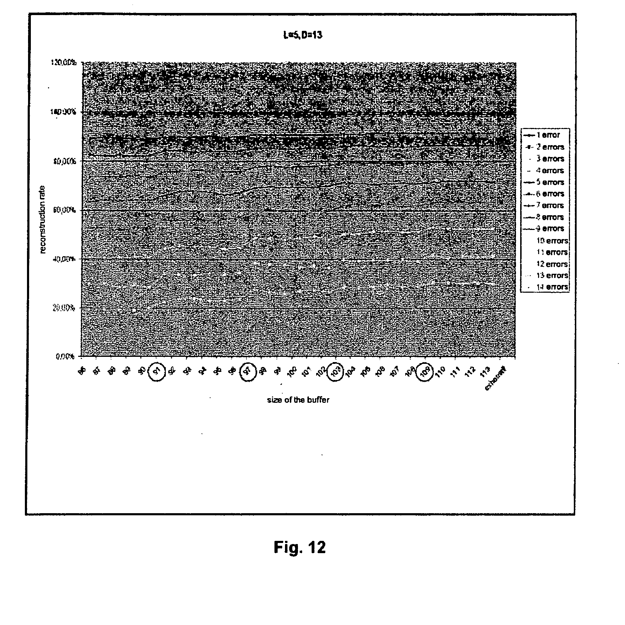

Figure 12 represents simulation results for a choice of L=5 and D=13 when the size of the buffer takes values varying from 86 to 113 packets long. The various rows represent the correction rates for a given number of packets lost randomly from the L*D data packets and the L+D corrector packets.

The first result that may be seen is that the degradation of the correction rate of the method is not as large as one might have feared. For example, if we consider a number of 8 errors out of the data packets and the corrector packets, it may be seen that with a complete buffer (of 113 packets) the correction rate is 72% whereas the use of a minimum buffer (of 86 packets) the correction rate is 63%. This signifying that a decrease of 24% of the size of the buffer leads to only a decrease of 9% of the correction rate.

A second observation shows that the correction rate does not alter linearly with the size of the buffer but there exist plateaux corresponding to significant drops in the correction rate. These plateaux are found every L+1 packets exactly, this corresponding to a decrement of 1 of the maximum number of columns (data plus FEC) available simultaneously in the buffer.

Now that we have seen that the use of a partial buffer has no overly significant consequences on the degradation of the correction rate, it is necessary to compare the rates obtained for a fixed size of buffer as a function of the choice of L and D.

If we consider a fixed size of buffer of 170 packets for example, the configuration which maximizes the use of the buffer is (L, D)=(8, 10). Specifically, this configuration requires a complete buffer of (L+1)*(D+2)+L²-2 = 170.

Let us consider a choice of configuration of (7, 14) making it possible to vary the size of the buffer between 122 and 175. This configuration is therefore compatible with the use of a buffer of 170 packets.

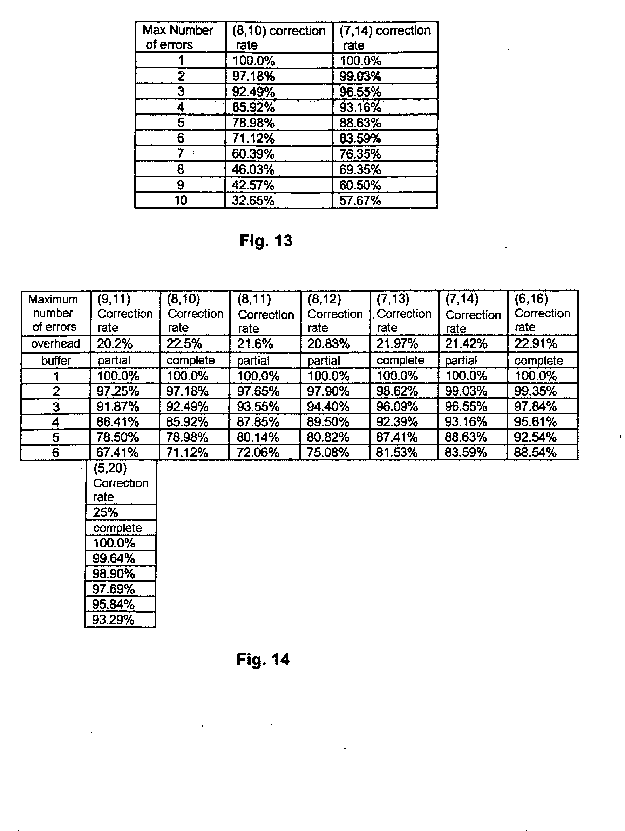

If we compare the error correction rate, we observe that by choosing an FEC scheme based on a larger matrix, better results are obtained despite the use of a partial buffer. The table in Figure 13 shows the results obtained by simulation for a number of errors of up to 10. We also observe that the (7,14) scheme offers much better results despite its degraded use than the (8,10) scheme used with a complete buffer.

Figure 14 shows the result of the simulations for the following schemes:
(L,D)=(9,11);(8,10);(8,11);(8,12);(7,13);(7,14);(6,16); (5,20).

Here again, it may be seen that for a fixed L, for example 8, the results with D equal to 11 or 12 and hence a partial buffer give better results than D equal to 10 with a complete buffer.

These simulation results which may be amazing at first may be explained. When a partial buffer is used, it is not possible at a given moment for the buffer to contain all the data packets and the corrector packets belonging to the same matrix of packets. Nevertheless the buffer will receive all these packets in time. The buffer may be seen as sliding over the array of the packets of the data stream in the course of time. For example, if a buffer is 99 packets long and if the matrix is 100 packets, initially the buffer will contain packets numbered 1 to 99, whereas subsequently it will contain packets numbered 2 to 100. As a result of this, the only errors that it will not be possible to correct with such a scheme will be the errors whose correction requires the use of packets numbered 1 and 100. All the other errors will be corrected in the same way as if a complete buffer were used.

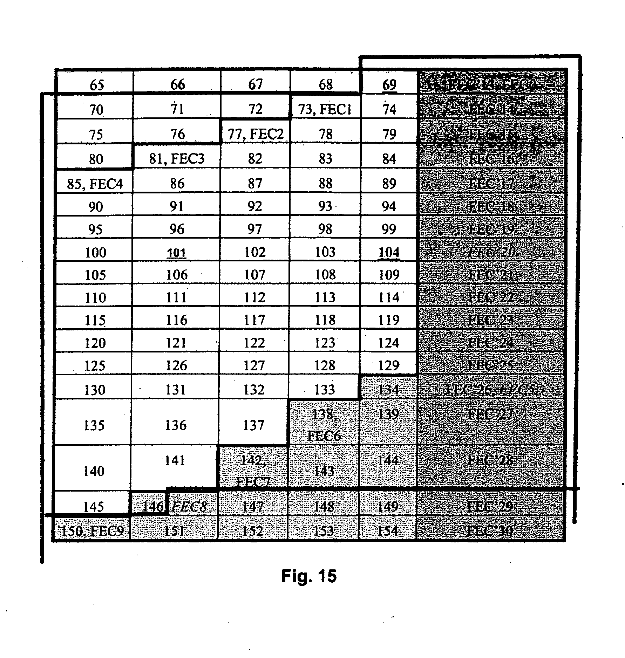

Figure 15 represents such an example where the error configuration may be corrected through a complete buffer whereas the correction is not possible using a partial buffer. In this configuration where L=5 and D=13, the complete buffer is a buffer of 113 packets (from packet numbered 65 to packet FEC9) whereas the FEC scheme uses a partial buffer of 102 packets only. The packets underlined are considered to be lost whereas the packets whose index number is italicized are required for their reconstruction. In a first position of the buffer, from packet number 69 to packet number 146, no packet may be corrected since the correction of packet number 101 requires corrector packet FEC8 which is not yet in the buffer. Packet numbered 104 requires packet 101, whereas the correction of packet 69 requires packet 104. When the buffer contains packets numbered FEC'13 to FEC8, packet 101 may be corrected by virtue of packet FEC8, whereas packet 104 is corrected by virtue of packet 101 and of packet FEC'20 but now that packet 69 has exited the buffer, it will no longer be correctable. Packet 69 will therefore never be reconstructed.

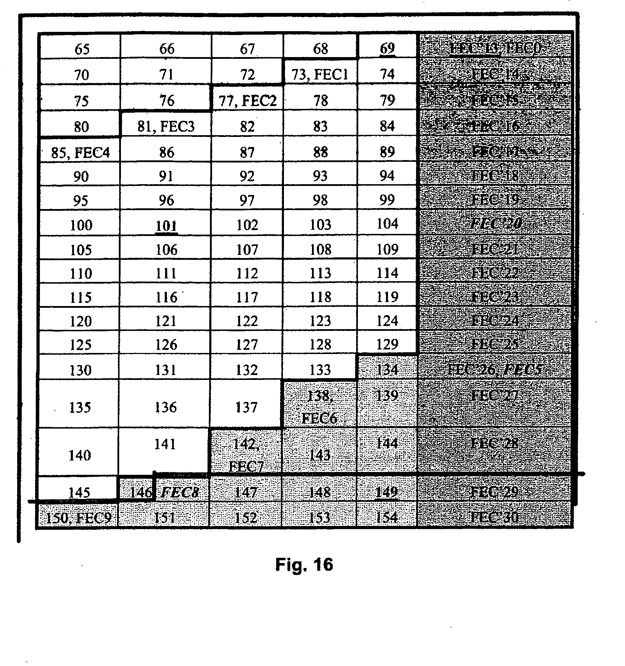

Figure 16 for its part represents an example where all the errors may be corrected despite the use of the partial buffer. In a first position of the buffer, marked in the figure, packet 69 will be correctable by virtue of FEC5 whereas packet 101 is corrected by virtue of FEC'20. At this moment packet 149 is not in the buffer, but slightly later, upon receipt of packet FEC'29, the nonreceipt of packet 149 is detected and the packet may be reconstructed.

It is therefore seen that a partial buffer does not contain the entirety of the data packets and of the associated corrector packets for a matrix. The method based on the use of a partial buffer therefore amounts to applying the reconstruction function to a subset of the matrix and of its associated corrector packets.

The partial buffer mechanism impacts only on the client and induces no server side modification.

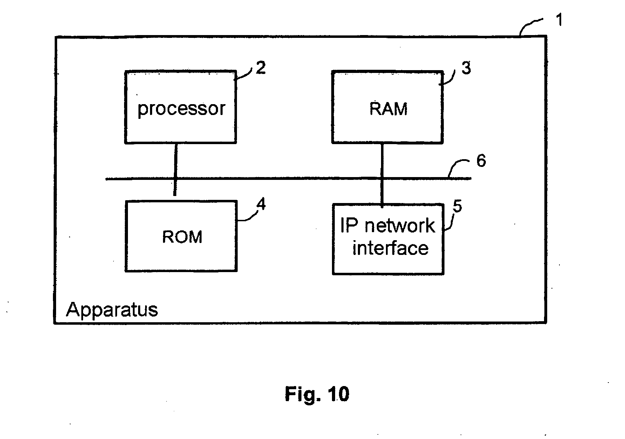

Figure 10 represents the internal architecture of a sender or receiver apparatus 1 which possesses read only memory (ROM 4) allowing it to store programs and data, random access memory (RAM 3) which allows it to load these programs with a view to execution by the processor 2. This apparatus is connected to an IP type network by a network interface 5, thereby allowing it to send or receive the streams of digital data packets. These components communicate by way of an internal bus 6.

## Claims

1. Method of receiving stream of digital data packets comprising:
- at the level of the receiver a step of receiving data packets with error corrector packets calculated by applying a corrector function to rows and columns of these data packets arranged within nonrectangular matrices, the rows and the columns of the nonrectangular matrix being defined by the index of the first packet, an increment step size and the total number of packets of which they are composed;
- at the level of the receiver a step of storing the data packets and the corrector packets received;
- at the level of the receiver a step of reconstructing the lost packets consisting of the application of the corrector function to the set of packets stored;
**characterized in that** the reconstruction function is applied to a restricted set of packets not containing all the data packets and the corrector packets involved in the protection of a matrix of data packets, the restricted set of packets being defined by the size of a buffer of the receiver used to temporally store the received data and error corrector packets.

2. Device to be connected to a communication network comprising means to receive data packets (5), means (5) to receive error corrector packets calculated by applying a corrector function to rows and columns of these data packets arranged within nonrectangular matrices, the rows and the columns of the nonrectangular matrix being defined by the index of the first packet, an increment step size and the total number of packets of which they are composed, means (3) to store the data packets and the corrector packets received, means (2) to reconstruct the lost packets by applying the corrector function to the set of packets stored, **characterized in that** the means to reconstruct lost packets are applied to a restricted set of packets not containing all the data packets and the corrector packets involved in the protection of a matrix of data packets, the restricted set of packets being defined by the size of a buffer of the receiver used to temporally store the received data and error corrector packets.

## Patentansprüche

1. Verfahren zum Empfangen eines Stroms digitaler Datenpakete, wobei das Verfahren umfasst:
- auf der Ebene des Empfängers einen Schritt des Empfangens von Datenpaketen mit Fehlerkorrekturpaketen, die durch Anwenden einer Korrekturfunktion auf die Zeilen und Spalten dieser Datenpakete, die innerhalb nicht rechteckiger Matrizen angeordnet sind, berechnet werden, wobei die Zeilen und die Spalten der nicht rechteckigen Matrix durch den Index des ersten Pakets, eine Inkrementschrittweite und die Gesamtzahl der Pakete, aus denen sie bestehen, definiert sind;
- auf der Ebene des Empfängers einen Schritt des Speicherns der empfangenen Datenpakete und der empfangenen Korrekturpakete;
- auf der Ebene des Empfängers einen Schritt des Rekonstruierens der verlorenen Pakete, der aus der Anwendung der Korrekturfunktion auf die Menge der gespeicherten Pakete besteht;
**dadurch gekennzeichnet, dass** die Rekonstruktionsfunktion auf eine eingeschränkte Menge von Pakten angewendet wird, die nicht alle Datenpakete und die an dem Schutz einer Matrix von Datenpaketen beteiligten Korrekturpakete enthält, wobei die eingeschränkte Menge von Paketen durch die Größe eines zum vorübergehenden Speichern der empfangenen Daten- und Fehlerkorrekturpakete verwendeten Puffers des Empfängers definiert ist.

2. Vorrichtung, die mit einem Kommunikationsnetz zu verbinden ist, wobei die Vorrichtung Mittel (5) zum Empfangen von Datenpaketen, Mittel (5) zum Empfangen von Fehlerkorrekturpaketen, die durch Anwenden einer Korrekturfunktion auf die Zeilen und Spalten dieser Datenpakete, die innerhalb nicht rechteckiger Matrizen angeordnet sind, berechnet werden, wobei die Zeilen und die Spalten der nicht rechteckigen Matrix durch den Index des ersten Pakets, eine Inkrementschrittweite und die Gesamtzahl der Pakete, aus denen sie bestehen, definiert sind, Mittel (3) zum Speichern der empfangenen Datenpakete und der empfangenen Korrekturpakete, Mittel (2) zum Rekonstruieren der verlorenen Pakete durch Anwenden der Korrekturfunktion auf die Menge der gespeicherten Pakete umfasst, **dadurch gekennzeichnet, dass** die Mittel zum Rekonstruieren verlorener Pakete auf eine eingeschränkte Menge von Paketen angewendet werden, die nicht alle Datenpakete und die an dem Schutz einer Matrix von Datenpaketen beteiligten Korrekturpakete enthält, wobei die eingeschränkte Menge von Paketen durch die Größe eines zum vorübergehenden Speichern der empfangenen Daten- und Fehlerkorrekturpakete verwendeten Puffers des Empfängers definiert ist.

## Revendications

1. Procédé de réception d'un flux de paquets de données numériques comprenant :
- au niveau du récepteur, une étape de réception de paquets de données avec des paquets correcteurs d'erreur calculés en appliquant une fonction correctrice aux lignes et aux colonnes de ces paquets de données rangés au sein de matrices non rectangulaires, les lignes et les colonnes de la matrice non rectangulaire étant définies par l'indice du premier paquet, un pas d'incrément et le nombre total de paquets les composant ;
- au niveau du récepteur, une étape de stockage des paquets de données et des paquets correcteurs reçus ;
- au niveau du récepteur, une étape de reconstruction des paquets perdus, consistant en l'application de la fonction correctrice sur l'ensemble des paquets stockés,
**caractérisé en ce que** la fonction de reconstruction est appliquée à un ensemble de paquets restreint ne contenant pas tous les paquets de données et les paquets correcteurs impliqués dans la protection d'une matrice de paquets de données, l'ensemble de paquets restreint étant défini par la taille d'une mémoire tampon du récepteur utilisée pour stocker temporairement les paquets de données et les paquets correcteurs reçus.

2. Dispositif se connectant à un réseau de communication comprenant des moyens de réception de paquets de données (5), des moyens (5) de réception de paquets correcteurs d'erreur calculés en appliquant une fonction correctrice aux lignes et aux colonnes de ces paquets de données rangés au sein de matrices non rectangulaires, les lignes et les colonnes de la matrice non rectangulaire étant définies par l'indice du premier paquet, un pas d'incrément et le nombre total de paquets les composant, des moyens (3) de stockage des paquets de données et des paquets correcteurs reçus, des moyens (2) de reconstruction des paquets perdus en appliquant la fonction correctrice sur l'ensemble des paquets stockés, **caractérisé en ce que** les moyens de reconstruction des paquets perdus sont appliqués à un ensemble de paquets restreint ne contenant pas tous les paquets de données et les paquets correcteurs impliqués dans la protection d'une matrice de paquets de données, l'ensemble de paquets restreint étant défini par la taille d'une mémoire tampon du récepteur, utilisée pour stocker temporairement les paquets de données et les paquets correcteurs d'erreur reçus.
